# EUROPÄISCHE PATENTANMELDUNG

(11) **EP 1 729 557 A2**
(43) Veröffentlichungstag der Anmeldung: **06.12.2006**
(21) Anmeldenummer: 06010568.1
(22) Anmeldetag: 23.05.2006
(51) Int. Cl.: H05K 7/20, H01L 23/473

(54) **Vorrichtung zur Kühlung von elektronischen Bauelementen**

(30) Priorität: 31.05.2005 DE 102005025381
(71) Anmelder: Behr Industry GmbH & Co. KG, 70469 Stuttgart (DE)
(72) Erfinder: Flesch, Markus, 70806 Kornwestheim (DE); Siebrecht, Thomas, 71642 Ludwigsburg (DE)
(74) Vertreter: Mantel, Berthold Friedrich

(57) **Zusammenfassung**

Die Erfindung betrifft eine Vorrichtung (1) zur Kühlung von elektronischen Bauelementen, im Wesentlichen bestehend aus plattenförmigen, einen als Strömungskanal ausgebildeten Hohlraum zwischen sich einschließenden Bauteilen (2, 8) mit Anschlüssen (5, 6) für ein flüssiges, den Strömungskanal durchströmendes Kühlmittel, wobei ein plattenförmiges Bauteil als gut wärmeleitende, vorzugsweise metallische Platte (8) ausgebildet und wärmeleitend mit den elektronischen Bauelementen verbunden ist.

Es wird vorgeschlagen, dass der Strömungskanal in seiner Anordnung und Ausbildung, insbesondere bezüglich seiner Strömungslänge zwischen den Kühlmittelanschlüssen (5, 6) und bezüglich seines Strömungsquerschnittes an die Lage von Stellen hoher Wärmeentwicklung durch die elektronischen Bauelemente anpassbar ist.

## Beschreibung

Die Erfindung betrifft eine Vorrichtung zur Kühlung von elektronischen Bauelementen nach dem Oberbegriff des Patentanspruches 1 - bekannt durch die DE 199 11 205 A1.

Kühlvorrichtungen für elektronische Bauelemente sind in verschiedenen Bauarten bekannt, wobei die Kühlung entweder durch Umgebungsluft oder durch ein flüssiges Kühlmittel erfolgt. Durch die EP 0 278 240 A2 wurde ein Kühlkörper mit einer wärmeleitenden, metallischen Grundplatte bekannt, auf welcher ein Kühlelement in Form eines Rippenpaketes durch Lötung befestigt ist, welches durch einen Luftstrom gekühlt wird. Die wärmeleitende Grundplatte befindet sich dabei in wärmeleitendem Kontakt mit den elektronischen Bauelementen. Durch die DE 198 06 978 A1 wurde eine Vorrichtung zur Kühlung elektronischer Bauelemente durch Konvektion bekannt, wobei ein Kühlluftstrom durch mit Rippen bestückte Kanäle eines Kühlkörpers zur Wärmeabfuhr geleitet wird. Der Kühlkörper ist wärmeleitend mit den elektronischen Bauteilen verbunden.

Durch die DE 41 31 739 A1 der Anmelderin wurde eine Kühleinrichtung für elektrische Bauelemente bekannt, wobei zwei plattenförmige Bauelemente, eine wärmeleitende Grundplatte und eine Deckplatte, miteinander verbunden sind und einen Hohlraum einschließen, welcher von einem flüssigen Kühlmittel durchströmt wird. Zur Erhöhung des Wärmeüberganges ist in dem Hohlraum eine Einlage zur Turbulenzerzeugung angeordnet und vorzugsweise mit der Grundplatte verlötet. Damit wird eine wirksame Wärmeabfuhr der durch die elektrischen Bauelemente erzeugten Verlustleistung erreicht.

Durch die DE 199 11 205 A1, von der die Erfindung ausgeht, wurde eine ähnliche flüssigkeitsgekühlte Vorrichtung für elektronische Bauelemente bekannt, wobei eine Grundplatte aus einem metallischen Werkstoff und eine Deckplatte aus einem Kunststoff hergestellt sind und zwischen sich einen als Strömungskanal ausgebildeten Hohlraum mit einer Kühlrippe (so genannte Turbulenzeinlage) einschließen, welcher von dem flüssigen Kühlmittel durchströmt wird. In einer bevorzugten Ausführungsform sind die Kühlmittelanschlüsse auf derselben Seite angeordnet, so dass eine Umlenkung des Kühlmittels im Hohlraum bewirkt wird. Nachteilig bei den bekannten Kühlvorrichtungen, auch den flüssigkeitsgekühlten Vorrichtungen, ist der relativ große Bauraum, der für die Wärmeabfuhr von größeren Verlustleistungen - wie sie z. B. bei einer Kraftfahrzeugelektronik auftreten - erforderlich ist.

Es ist Aufgabe der vorliegenden Erfindung, eine Vorrichtung zur Kühlung von elektronischen Bauelementen der eingangs genannten Art in ihrer Effizienz zu verbessern und hinsichtlich ihres Bauraumes zu reduzieren.

Diese Aufgabe wird durch die Merkmale des Patentanspruches 1 gelöst. Erfindungsgemäß ist vorgesehen, dass der vom Kühlmittel durchströmbare Strömungskanal derart an die örtlich unterschiedlichen Verhältnisse hinsichtlich der abzuführenden Wärme angepasst ist, dass sich eine annähernd gleichmäßige Temperaturverteilung auf der gesamten Kontaktfläche zwischen Elektronik und Kühlplatte ergibt. Die Erfindung geht von der Erkenntnis aus, dass der Wärmeeintrag aus einer Einheit von elektronischen Bauelementen, einer so genannten Platine, wegen der unterschiedlichen Verlustleistung der einzelnen Bausteine inhomogen in Bezug auf die Fläche der Platine ist, die in wärmeleitendem Kontakt mit der Kühl- oder Deckplatte der Kühlvorrichtung steht. Andererseits ist beim Stand der Technik die Wärmeabfuhr durch ein Kühlmittel, welches die Kühlplatte überströmt, relativ gleichmäßig, so dass sich besonders heiße Stellen, so genannte hot spots bilden. Die Erfindung sieht nun vor, dass durch eine angepasste Ausgestaltung und Anordnung des Strömungskanals, beispielsweise hinsichtlich dessen Strömungslänge und dessen Strömungsquerschnitt die Wärmeübergangsverhältnisse variabel, d. h. an die spezifischen Gegebenheiten der elektronischen Baueinheit angepasst sind. So kann beispielsweise durch eine Verengung des Strömungskanals im Bereich eines hot spots eine erhöhte Strömungsgeschwindigkeit des Kühlmittels und damit eine verbesserte Wärmeabfuhr erreicht werden. Das Temperatumiveau wird dadurch nivelliert. Andererseits kann durch gezielte Umlenkungen des Strömungskanals das Kühlmittel an die heißen Stellen, d. h. an die Bereiche mit relativ hohem Wärmeeintrag geführt werden. Mit dieser gezielten Wärmeabfuhr kann eine höhere Kühlleistung bei geringem Bauraum erreicht werden.

Vorteilhafte Ausgestaltungen der Erfindung ergeben sich aus den Unteransprüchen. Vorteilhafterweise kann der Strömungsweg (oder die Strömungslänge), d. h. die Strecke, die das Strömungsmedium zwischen Eintritt und Austritt in der Kühlvorrichtung zurücklegt, durch eine oder mehrere Umlenkungen erhöht werden. Damit wird nicht nur die Kühlleistung erhöht, sondem das Kühlmittel wird gezielt an bevorzugte Stellen eines hohen Wärmeintrags seitens der Elektronik geführt. Damit wird eine gute Wärmeabfuhr und eine Homogenisierung der Temperaturverteilung erreicht. Vorteilhafterweise werden die Umlenkungen des Kühlmittels durch Stege erzielt, welche z. B. einen mäanderförmigen Verlauf des Kühlmittels durch die Kühlvorrichtung erzwingen. In vorteilhafter Ausgestaltung können die Stege in eine Platte der Kühlvorrichtung, einen so genannten Boden, eingeformt, d. h. einstückig ausgebildet werden. Der Boden wird dabei vorzugsweise aus einem Aluminiumblech in einem Folgeverbundwerkzeug hergestellt, wobei auch Ein- und Auslasskanäle für das Kühlmittel gleichzeitig miteingeformt werden. Zur Steigerung des Wärmeüberganges auf der Kühlmittelseite sind so genannte Turbulenzeinlagen vorgesehen, welche hinsichtlich ihrer Ausbildung dem Stand der Technik entsprechen und sowohl mit dem Boden als auch mit der Deckplatte der Kühlvorrichtung verlötbar sind. Dadurch entsteht eine kompakte, innendruckfeste, gut wärmeleitende Kühlvorrichtung. Die Herstellung ist äußerst einfach und damit preisgünstig, da der Boden und die Deckplatte aus Blechteilen, vorzugsweise Aluminiumblech durch spanlose Bearbeitung (Stanzen und Prägen) auf einem Werkzeug, einem so genannten Folgeverbundwerkzeug, herstellbar sind.

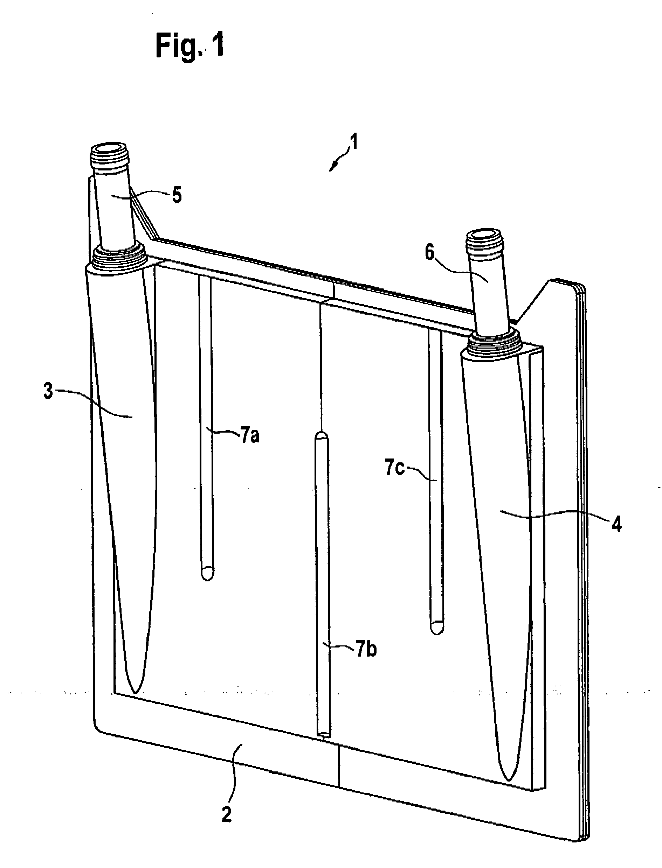

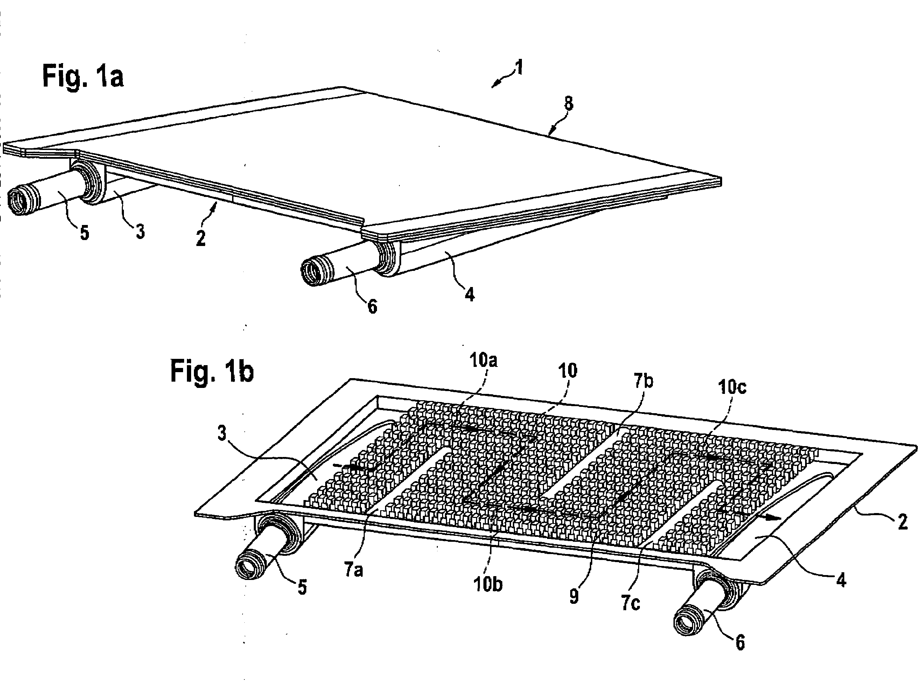

Ein Ausführungsbeispiel der Erfindung ist in der Zeichnung dargestellt und wird im Folgenden näher beschrieben. Es zeigen
- Fig. 1: eine Kühlvorrichtung in perspektivischer Darstellung in einer Ansicht auf den Boden,
- Fig. 1 a: die Kühlvorrichtung gemäß Fig. 1 in einer Ansicht auf die Deckplatte,
- Fig. 1 b: die Kühlvorrichtung gemäß Fig. 1 ohne Deckplatte,
- Fig. 2: die Kühlvorrichtung gemäß Fig. 1 in Explosivdarstellung.

Fig. 1 zeigt eine Kühlvorrichtung 1 zur Kühlung von nicht dargestellten elektronischen Bauelementen, vorzugsweise einer elektronischen Motorsteuerung für Kraftfahrzeuge. Die Kühlvorrichtung 1 weist einen Boden 2 auf, aus welchem ein Einlasskanal 3 und ein Auslasskanal 4 für ein flüssiges Kühlmittel ausgeformt sind. In den Einlasskanal 3 ist ein Einlassstutzen 5 und in den Auslasskanal 4 ein Auslassstutzen 6 gesteckt und dicht mit dem Boden 2 verlötet. In den Boden 2 sind ferner Trennstege 7a, 7b, 7c eingeformt, welche sich mit ihrer Ausprägung zur Innenseite der Kühlvorrichtung erstrecken.

Fig. 1a zeigt die Kühlvorrichtung 1 in einer anderen Ansicht, nämlich mit Blick auf eine Deckplatte 8, welche sich auf der dem Boden 2 gegenüberliegenden Seite befindet und randseitig mit dem Boden 2 verbunden, vorzugsweise verlötet ist. Der Boden 2 mit seinen Ein- und Auslasskanälen 3, 4 befindet sich also auf der Unterseite dieser Darstellung. Die Deckplatte 8 ist im Wesentlichen glatt und eben ausgebildet und stehtwas hier nicht dargestellt ist - in wärmeleitendem Kontakt mit einer Platine, auf welcher Elektronikbausteine befestigt sind. Die nicht dargestellte Platine mit den Elektronikbausteinen liegt flächig auf der Deckplatte 8 auf und ist vorzugsweise mittels eines wärmeleitenden Klebers mit dieser verklebt. Die nicht dargestellte Platine und die Kühlvorrichtung 1 bilden somit eine Baueinheit, die als solche montierbar ist, z. B. als kühlbare Motorsteuerung in einem Kraftfahrzeug.

Fig. 1b zeigt die Kühlvorrichtung 1 ohne die Deckplatte 8, d. h. die Deckplatte 8 ist abgenommen und gibt den Blick frei in das Innere der Kühlvorrichtung 1. Man erkennt die Trennstege 7a, 7b, 7c sowie die offenen Einlass- und Auslasskanäle 3, 4. Zwischen den Kanälen 3, 4 und den Trennstegen 7a,. 7b, 7c ist eine so genannte Turbulenzeinlage 9 eingesetzt, welche an den Stellen der Trennstege 7a, 7b, 7c ausgespart ist. Die Kühlvorrichtung 1 ist vorzugsweise an den Kühlmittelkreislauf einer nicht dargestellten Brennkraftmaschine des Kraftfahrzeuges angeschlossen und wird vom Kühlmittel durchströmt. Aufgrund der Trennstege 7a, 7b, 7c wird der Kühlmittelströmung ein mäanderförmiger Verlauf aufgezwungen ― dargestellt durch einen gestrichelten Pfeil 10 mit drei Umlenkungen 10a, 10b, 10c.

In der zeichnerischen Darstellung sind die Trennstege 7a, 7b, 7c etwa in gleichen Abständen zueinander angeordnet und weisen auch etwa die gleiche Länge auf. Dies ist jedoch nur ein bevorzugtes Ausführungsbeispiel ― je nach Lage der elektronischen Bausteine und je nach der Höhe ihrer Verlustleistung kann der Strömungsverlauf auch derart variiert werden, dass sich für die Kühlmittelströmung Beschleunigungsstrecken und höhere Strömungsgeschwindigkeiten ergeben, welche eine erhöhte Wärmeabfuhr zur Folge haben. Dies kann durch eine Verengung des Strömungsquerschnittes erreicht werden, sei es durch eine Verringerung des Abstandes von benachbarten Trennstegen oder durch eine Krümmung, Verlängerung oder Verkürzung der Trennstege, so dass der Strömungsquerschnitt in den Umlenkbereichen 10a, 10b, 10c. unterschiedlich ausfällt. Auch durch die Wahl der Turbulenzeinlagen mit einem höheren oder geringeren Strömungswiderstand lässt sich der Wärmeübergang örtlich beeinflussen, oder einzelne Abschnitte des Strömungsweges weisen überhaupt keine Turbulenzbleche auf. Durch diese und andere aus dem Stand der Technik bekannte Maßnahmen kann der Wärmeübergang und damit die Wärmeabfuhr örtlich variabel gestaltet und an den inhomogenen Wärmeeintrag aus der Platine der elektronischen Bauelemente angepasst werden.

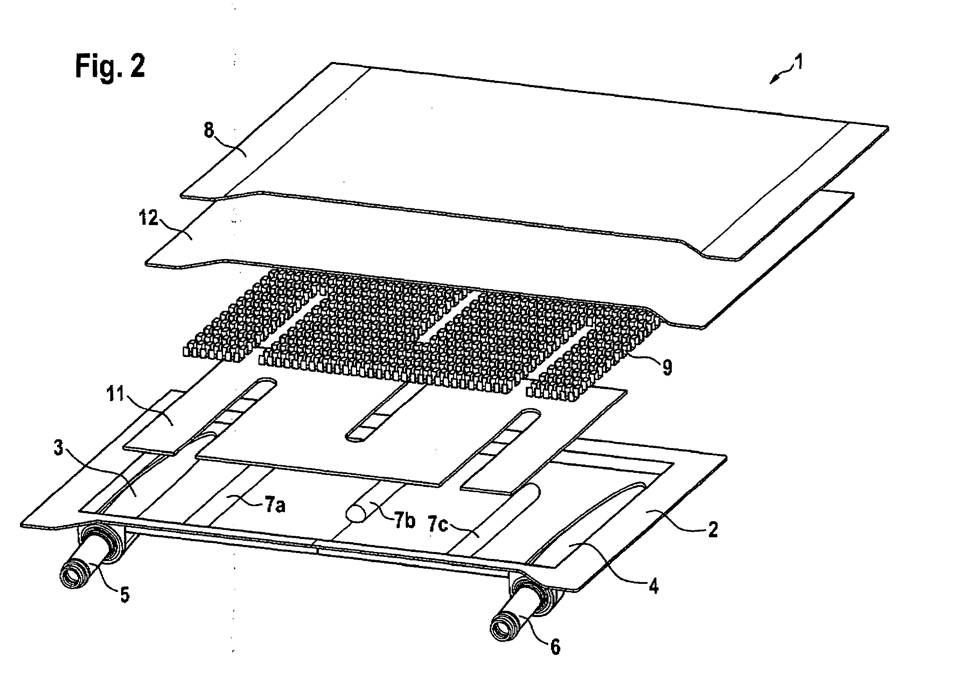

Fig. 2 zeigt die Kühlvorrichtung 1 in einer Explosivdarstellung, wobei die Einzelteile vor ihrer Montage beabstandet und in paralleler Anordnung dargestellt sind. Es werden die gleichen Bezugszahlen für gleiche Teile verwendet. Zwischen Boden 2 und Turbulenzblech 9 ist ein folienförmiger Lotträger (Lotfolie) 11 dargestellt, welcher im Bereich der Trennstege 7a, 7b, 7c ausgespart ist. Zwischen Deckplatte 8 und Turbulenzblech 9 ist ein weiterer Lotträger (Lotfolie) 12 angeordnet. Beide Lotfolien 11, 12 bewirken nach dem Zusammenbau aller Teile, welche vorzugsweise aus Aluminiumlegierungen hergestellt sind, eine Verlötung von Boden 2 und Deckplatte 8 in einem umlaufenden Randbereich sowie im Bereich der Trennstege 7a, 7b, 7c. Ebenso wird das Turbulenzblech 9 sowohl mit der Deckplatte 8 als auch mit dem Boden 2 verlötet. Dadurch wird ein Hohlraum geschaffen, welcher als mäandrierender Strömungskanal zwischen Ein- und Auslasskanal ausgebildet ist. Wie bereits erwähnt, ist der Strömungskanal an die "Topografie" der Elektronikplatine angepasst und daher variabel, um eine optimale Wärmeabfuhr über das strömende Kühlmittel zu erreichen.

Wie oben erwähnt, wird auf der glatten Deckplatte 8 eine Platine mit Elektronikbauelementen wärmeleitend befestigt, vorzugsweise verklebt, so dass eine transportfähige und montierbare Baueinheit entsteht.

## Patentansprüche

1. Vorrichtung zur Kühlung von elektronischen Bauelementen, im Wesentlichen bestehend aus plattenförmigen, einen als Strömungskanal ausgebildeten Hohlraum zwischen sich einschließenden Bauteilen mit Anschlüssen (5, 6) für ein flüssiges, den Strömungskanal durchströmendes Kühlmittel, wobei ein plattenförmiges Bauteil als gut wärmeleitende, vorzugsweise metallische Platte (8) ausgebildet und wärmeleitend mit den elektronischen Bauelementen verbunden ist, **dadurch gekennzeichnet, dass** der Strömungskanal (10) in seiner Anordnung und Ausbildung, insbesondere bezüglich seiner Strömungslänge zwischen den Kühlmittelanschlüssen (5, 6) und bezüglich seines Strömungsquerschnittes an die Lage von Stellen hoher Wärmeentwicklung durch die elektronischen Bauelemente anpassbar ist.

2. Vorrichtung nach Anspruch 1, **dadurch gekennzeichnet, dass** der Strömungskanal (10) mindestens eine, vorzugsweise drei Umlenkungen (10a, 10b, 10c) aufweist.

3. Vorrichtung nach Anspruch 1 oder 2, **dadurch gekennzeichnet, dass** der wärmeleitenden Platte (Deckplatte 8) eine zweite, als Boden (2) ausgebildete Platte zugeordnet ist, welche mindestens einen, vorzugsweise drei Trennstege (7a, 7b, 7c) für die Umlenkung des Kühlmittels aufweist.

4. Vorrichtung nach Anspruch 3, **dadurch gekennzeichnet, dass** der Boden (2) Ein- und Auslasskanäle (3, 4) aufweist.

5. Vorrichtung nach Anspruch 3 oder 4, **dadurch gekennzeichnet, dass** der Boden (2) als Tiefziehteil, vorzugsweise aus einem Aluminiumblech herstellbar ist,.

6. Vorrichtung nach mindestens einem der Ansprüche 1 bis 5, **dadurch gekennzeichnet, dass** zwischen der wärmeleitenden Platte (Deckplatte 8) und dem Boden (2) im Bereich des Strömungskanals (10) Turbulenzerzeuger (9) angeordnet sind.

7. Vorrichtung nach mindestens einem der Ansprüche 1 bis 6, **dadurch gekennzeichnet, dass** die Deckplatte (8), der Boden (2) und die Turbulenzerzeuger (9) miteinander verlötbar sind.

8. Vorrichtung nach mindestens einem der vorhergehenden Ansprüche, **dadurch gekennzeichnet, dass** die Kühlvorrichtung (1) mit den elektronischen Bauelementen eine Baueinheit bildet.
